# EUROPEAN PATENT APPLICATION

(11) **EP 1 796 148 A2**
(43) Date of publication of application: **13.06.2007**
(21) Application number: 06025341.6
(22) Date of filing: 07.12.2006
(51) Int. Cl.: H01L 21/04

(54) **Silicon carbide semiconductor device and method for producing the same**

(30) Priority: 08.12.2005 JP 2005354281
(71) Applicant: NISSAN MOTOR CO., LTD., Yokohama-shi Kanagawa-ken (JP)
(72) Inventor: Tanimoto, Satoshi, Atsugi-shi Kanagawa 243-0192 (JP)
(74) Representative: Grünecker, Kinkeldey, Stockmair & Schwanhäusser Anwaltssozietät

(57) **Abstract**

A silicon carbide semiconductor device (10), includes: 1) a silicon carbide substrate (1;2) a silicide electrode configured to be formed by depositing a contact parent material on the silicon carbide substrate (1) in such a manner as to cause a solid phase reaction, the silicide electrode (52) being a lower carbon content silicide electrode including: i) silicon, and ii) carbon smaller than the silicon in mol number; and 3) an upper conductor film (3) deposited to the silicide electrode (52).

## Description

### BACKGROUND OF THE INVENTION

### 1. Field of the Invention

The present invention relates to a silicon carbide semiconductor device and a method for producing the same.

### 2. Description of the Related Art

Semiconductor silicon carbide (SiC) has excellent features such as high electric breakdown field, high saturation electron velocity, high thermal conductivity, high heat resistance, high chemical stability, tough mechanical strength and the like. In addition, the semiconductor silicon carbide can form a pn junction and grow a thermally oxidized silicon film. Therefore, the semiconductor silicon carbide is the semiconductor material that realizes a ultra-low loss power device, a high frequency power amplifying device, a high temperature operation switching device and the like which cannot be achieved by Si. The semiconductor silicon carbide having the above features has been expected from the past and a basic research thereof has been done continuously. Recently, with commercialization of a single crystal substrate having a large bore diameter and a relatively high quality, the above SiC electron devices and respective production technologies thereof have been eagerly developed in the semiconductor field, as shown in Japanese Patent Application Laid-Open No. 2003-318398 (= JP2003318398).

For producing the above SiC electron devices, forming of at least one ohmic contact is necessary. For forming the above ohmic contact according to a related art, a silicide electrode is formed on a part for the ohmic contact and an upper conductor film is formed on the part, thereby completing the ohmic contact.

According to the related art, however, after forming the contact structure, the upper conductor film may suddenly be stripped, thus decreasing yield of the SiC electron devices or causing the stripping failure after completing the SiC electron devices. Moreover, the above inconveniences are expected to occur even when the contact is not ohmic.

### SUMMARY OF THE INVENTION

It is therefore an object of the present invention to provide a silicon carbide semiconductor device where an upper conductor film thereof deposited to a silicide electrode is free from strip.

It is another object of the present invention to provide a method for producing the above silicon carbide semiconductor device.

According to a first aspect of the present invention, there is provided a silicon carbide semiconductor device, comprising: 1) a silicon carbide substrate; 2) a silicide electrode configured to be formed by depositing a contact parent material on the silicon carbide substrate in such a manner as to cause a solid phase reaction, the silicide electrode being a lower carbon content silicide electrode including: i) silicon, and ii) carbon smaller than the silicon in mol number; and 3) an upper conductor film deposited to the silicide electrode.

According to a second aspect of the present invention, there is provided a method for producing a silicon carbide semiconductor device which comprises: 1) a silicon carbide substrate; 2) a silicide electrode configured to be formed by depositing a contact parent material on the silicon carbide substrate in such a manner as to cause a solid phase reaction, the silicide electrode being a lower carbon content silicide electrode including: i) silicon, and ii) carbon smaller than the silicon in mol number; and 3) an upper conductor film deposited to the silicide electrode, the method comprising: 1) a first operation for depositing the contact parent material to the silicon carbide substrate; 2) a second operation for implementing a contact annealing, including the following sub-operations: i) heating the silicon carbide substrate to which the contact parent material is deposited, and ii) forming the silicide electrode by the solid phase reaction between the contact parent material and the silicon carbide substrate; 3) a third operation for segregating, to a surface of the silicide electrode, at least a part of carbon generated through the second operation, to thereby allow the silicide electrode to serve as the lower carbon content silicide electrode; 4) a fourth operation for removing the at least the part of the carbon segregated to the surface of the silicide electrode in the third operation; and 5) a fifth operation for depositing the upper conductor film to the following, after the removing of the carbon in the fourth operation: a surface of the silicide electrode serving as the lower carbon content silicide electrode through the third operation.

According to a third aspect of the present invention, there is provided a method for producing a silicon carbide semiconductor device which comprises: 1) a silicon carbide substrate; 2) a silicide electrode configured to be formed by depositing a contact parent material on the silicon carbide substrate in such a manner as to cause a solid phase reaction, the silicide electrode being a lower carbon content silicide electrode including: i) silicon, and ii) carbon smaller than the silicon in mol number; and 3) an upper conductor film deposited to the silicide electrode, wherein the silicon carbide substrate includes: 1) a first face contacting a Schottky electrode such that the silicon carbide semiconductor device is configured to serve as a vertical Schottky diode, and 2) a second face opposite to the first face, the lower carbon content silicide electrode being formed on the second face, the method comprising: 1) a first operation for covering the first face and the second face of the silicon carbide substrate with a thermally oxidized film; 2) a second operation including the following sub-operations: i) removing at least a part of the thermally oxidized film on the second face of the silicon carbide substrate, and ii) exposing, thereby, the second face of the silicon carbide substrate; 3) a third operation for depositing the contact parent material on the thus exposed second face; 4) a fourth operation for implementing a contact annealing, including the following sub-operations: i) heating the silicon carbide substrate to which the contact parent material is deposited, and ii) forming the silicide electrode by the solid phase reaction between the contact parent material and the silicon carbide substrate; 5) a fifth operation for segregating, to a surface of the silicide electrode, at least a part of carbon generated through the fourth operation, to thereby allow the silicide electrode to serve as the lower carbon content silicide electrode; 6) a sixth operation for removing the at least the part of the carbon segregated to the surface of the silicide electrode in the fifth operation; and 7) a seventh operation for segregating the upper conductor film to the following, after the removing of the carbon in the sixth operation: a surface of the silicide electrode serving as the lower carbon content silicide electrode through the fifth operation; wherein the method further comprising the following operations after the fifth operation: 8) an eighth operation including the following sub-operations: i) removing at least a part of the thermally oxidized film on the first face of the silicon carbide substrate, and ii) exposing, thereby, the first face of the silicon carbide substrate, and 9) a ninth operation for forming the Schottky electrode on the thus exposed first face of the silicon carbide substrate.

According to a fourth aspect of the present invention, there is provided a method for producing a silicon carbide semiconductor device which comprises: 1) a silicon carbide substrate; 2) a silicide electrode configured to be formed by depositing a contact parent material on the silicon carbide substrate in such a manner as to cause a solid phase reaction, the silicide electrode being a lower carbon content silicide electrode including: i) silicon, and ii) carbon smaller than the silicon in mol number; and 3) an upper conductor film deposited to the silicide electrode, wherein the silicon carbide semiconductor device further comprises: 1) a source electrode including the lower carbon content silicide electrode, and 2) a drain electrode including the lower carbon content silicide electrode, allowing the silicon carbide semiconductor device to serve as a field effect transistor configured to be a vertical metal-oxide-semiconductor, the method comprising: 1) a first operation for sequentially forming the following on a first face of the silicon carbide substrate by a selective impurity ion implantation: i) a precursor region of a p type base region, ii) a precursor region of a p⁺ type base region, and iii) a precursor region of an n⁺ type source region; 2) a second operation for forming the n⁺ type source region, the p type base region and the p⁺ type base region by a thermal annealing of the respective precursor regions; 3) a third operation including the following sub-operations: covering, with a first thermally oxidized film, the first face of the silicon carbide substrate on which face the n⁺ type source region, the p type base region and the p⁺ type base region are formed, and covering, with a second thermally oxidized film, a second face of the silicon carbide substrate; 4) a fourth operation including the following sub-operations: i) removing at least a part of each of the following: a) the first thermally oxidized film on the n⁺ type source region, and b) the first thermally oxidized film on the p⁺ type base region, ii) exposing, thereby, the n⁺ type source region and the p⁺ type base region, and iii) depositing the contact parent material on the thus exposed n⁺type source region and the thus exposed p⁺type base region; 5) a fifth operation including the following sub-operations: i) removing at least a part of the second thermally oxidized film on the second face of the silicon carbide substrate, ii) exposing, thereby, the second face of the silicon carbide substrate, and iii) depositing the contact parent material on the thus exposed second face of the silicon carbide substrate; 6) a sixth operation for implementing a contact annealing, including the following sub-operations: i) heating the silicon carbide substrate having the first face and the second face on each of which the contact parent material is thus deposited, and ii) forming the following by the solid phase reaction between the contact parent material and the silicon carbide substrate: a) a source electrode which is the silicide electrode contacting the n⁺ type source region and the p⁺ type base region, and b) a drain electrode which is the silicide electrode contacting the second face of the silicon carbide substrate; 7) a seventh operation for segregating, to a surface of the silicide electrode, at least a part of carbon generated through the contact annealing in the sixth operation, to thereby allow the silicide electrode to serve as the lower carbon content silicide electrode; 8) an eighth operation for removing the at least the part of the carbon segregated to the surface of the silicide electrode in the seventh operation; and 9) a ninth operation for depositing the upper conductor film to each of the following, after the removing of the carbon at the eighth operation: i) a surface of the source electrode serving as the lower carbon content silicide electrode through the seventh operation, and ii) a surface of the drain electrode serving as the lower carbon content silicide electrode through the seventh operation.

### BRIEF DESCRIPTION OF THE DRAWINGS

Fig. 1 is a cross sectional view of an essential part of an ohmic contact which includes a failure cause, according to a related art.
Fig. 2 is a cross sectional view of an essential part of a silicon carbide semiconductor device, according to a first embodiment of the present invention.
Fig. 3A to Fig. 3F show a method for producing the silicon carbide semiconductor device, according to the first embodiment of the present invention.
Fig. 4 is a cross sectional view of an essential part of a silicon carbide semiconductor device, according to a second embodiment of the present invention.
Fig. 5A to Fig. 5G show a method for producing the silicon carbide semiconductor device, according to the second embodiment of the present invention.
Fig. 6 is a cross sectional view of an essential part of a silicon carbide semiconductor device, according to a third embodiment of the present invention.
Fig. 7A to Fig. 7H show a method for producing the silicon carbide semiconductor device, according to the third embodiment of the present invention.

### DESCRIPTION OF THE PREFERRED EMBODIMENTS

For solving the above inconveniences according to the related art, the present inventors have made a thorough study on causes for the strip failure.

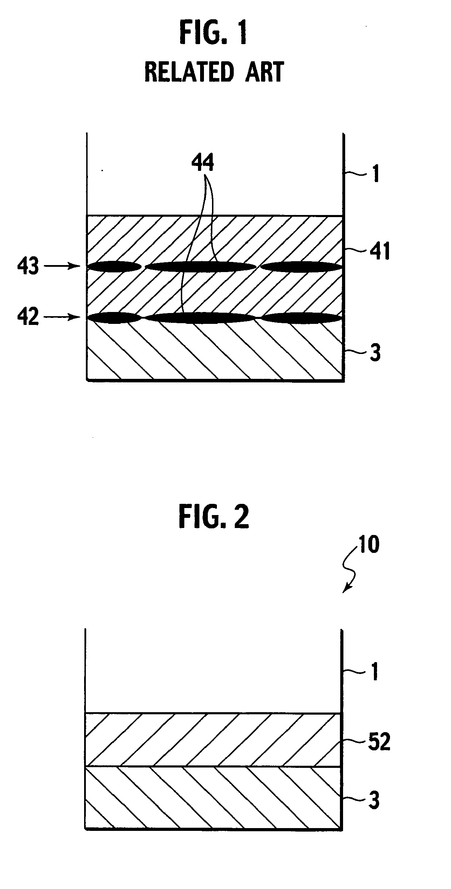

At first, the present inventors have determined where the strip is caused. Fig. 1 shows a structure used for the determination. The structure in Fig. 1 is produced according to the related art and shows a cross sectional view of an essential part of an ohmic contact which includes a failure cause. In Fig. 1, there is provided an n type SiC substrate 1 on (beneath in Fig. 1) which a silicide electrode 41 is formed by a solid phase reaction (caused by heating referred to as "contact annealing") between a contact parent material and the silicon carbide substrate 1. Moreover, there is provided an upper conductor film 3 on (beneath in Fig. 1) the silicide electrode 41.

After close observations of a plurality of failure samples, the strip was found in an interface (otherwise, referred to as "electrode-conductor interface 42") between the upper conductor film 3 and the silicide electrode 41 and in the silicide electrode 41 (otherwise, referred to as "silicide inner part 43"), as shown in the cross sectional view in Fig. 1. The strip ratio of the electrode-conductor interface 42 was relatively high, specifically about 80 % of total failures, leaving the other strips in the silicide inner part 43.

After physical analyses, a deposit 44 which seemed to be a graphite (carbon C), was detected in a great amount from the strip faces (i.e., electrode-conductor interface 42 and silicide inner part 43). Meanwhile, a Secondary Ion Mass Spectrometer (SIMS) was implemented for making comparison of carbon concentrations in the silicide electrode 41. The carbon concentration lower (upper in Fig. 1) than the strip faces (i.e., electrode-conductor interface 42 and silicide inner part 43) causing the strip was, unexpectedly, lower by one-digit than the carbon concentration of non-strip samples.

From metallurgical point of view, it is known that contact parent materials such as Ni, Co and the like contacting the SiC make the following solid phase reaction in a high temperature heating, thus easily forming the silicide while not forming the carbide:

Ni + 2SiC → NiSi₂ + 2C (contact parent material: Ni)

With the above facts and study, the strip failure is supposed to be caused by the following mechanism.

In an unstable over-saturated state or as a minor deposit, the carbon C generated by the above solid phase reaction (contact annealing) is dispersed and present in the entire inner area of the silicide electrode 41. When some stimulation is applied to the carbon C after the upper conductor film 3 is laminated, the carbon C is discharged rapidly and then is segregated (deposited) to the electrode-conductor interface 42 and the silicide inner part 43. In this segregating, the carbon C is in a form of a layer as the deposit 44 which seems to be the graphite. The deposit 44 is a frail material and has poor adhesion, thus being easily fragile with a slight stress applied to the deposit 44, thereby stripping off the upper conductor film 3.

Based on the above analytical results, the present inventors have come up with the following inference. "Before forming the upper conductor film, intentionally discharging and removing the excessive amount of carbon C dispersed (as a deposit which seems to be a graphite) in the silicide electrode can suppress the stripping of the upper conductor film." After various studies, the present inventors have found out several methods for discharging the excessive amount of carbon C and for removing the deposit which seems to be the graphite, and confirmed that the use of the above methods can bring about the inferred effects.

The present invention has been thus completed.

Under the present invention, there is provided a silicon carbide semiconductor device, comprising: 1) a silicon carbide substrate; 2) a silicide electrode configured to be formed by depositing a contact parent material on the silicon carbide substrate in such a manner as to cause a solid phase reaction, the silicide electrode being a lower carbon content silicide electrode including: i) silicon, and ii) carbon smaller than the silicon in mol number; and 3) an upper conductor film deposited to the silicide electrode.

As obvious from the reaction formula "Ni + 2SiC → NiSi₂ + 2C" described above, the carbon generated by the solid phase reaction (contact annealing) is the same in mol number as the silicon in silicide. The silicon carbide semiconductor device under the present invention, therefore, includes the i) silicon and ii) the carbon which is smaller than the silicon in mol number, by discharging and removing outside the silicide electrode at least a part of the generated carbon.

Hereinafter, referring to drawings, several embodiments of the present invention are to be explained in detail. In the following drawings, the same or similar parts are to be denoted by the same or similar reference numerals or signs, and the description thereof is, as the case may be, simplified or omitted. The drawings are schematic, and therefore i) thickness relative to plan-view dimension or ii) thickness ratio and the like of each layer is, as the case may be, not actual. Therefore, specific thickness or dimension should be determined referring to the following explanation. Moreover, relative dimension or ratio between the drawings is, as the case may be, not actual.

The embodiments of the present invention are applicable to all crystal faces including substrates of crystal systems such as 4H, 6H, 3C, 15R (where H denotes hexagonal system, C denotes cubic system, and R denotes rhombohedral system) and the like. For convenience sake, however, hereinafter described is 4H-SiC substrate. Being capable of bringing about an element feature that is the most excellent in various silicon carbide substrates, the 4H-SiC substrate to be described hereinafter is most promising today.

In the following descriptions, unless otherwise specified, those having SiC substrate on which an epitaxial layer, other film(s) or electrode is formed are referred to as "SiC substrate" or simply "substrate."

### [First embodiment]

Hereinafter described includes a silicon carbide semiconductor device 10 having a simple ohmic contact, and a method for producing the silicon carbide semiconductor device 10, according to a first embodiment of the present invention.

### <Structure>

Fig. 2 shows a cross sectional view of an essential part of the silicon carbide semiconductor device 10, according to the first embodiment of the present invention. In Fig. 2, there is provided an n type 4H-SiC substrate 1 which is a silicon carbide substrate. At least a surface layer of a contact face of the n type 4H-SiC substrate 1 is doped with a high-concentration n type impurity. The substrate 1 has the contact face formed with a lower carbon content silicide electrode 52 (for example, NiSi₂) which is formed by a contact annealing (solid phase reaction) and has a carbon content smaller than silicon content in mol number. The carbon content in mol number is 1/5 or less the silicon content, or preferably 1/10 or less the silicon content. The carbon concentration 1/5 or more the silicon concentration (in this case, still carbon concentration < silicon concentration) may bring about an effect of the present invention to a certain extent, decreasing occurrence of strip failure of an upper conductor film 3 (to be described afterward). The carbon concentration 1/5 or less the silicon concentration, however, shows an extremely remarkable effect, further decreasing occurrence of the strip failure of the upper conductor film 3, specifically, 2-digit decrease or more.

Moreover, the lower carbon content silicide electrode 52 has a thickness of 20 nm to 500 nm, or preferably 50 nm to 250 nm.

On (beneath in Fig. 2) the lower carbon content silicide electrode 52, there is formed the upper conductor film 3. The upper conductor film 3 may be made of a metalized film (for example, Ti/Ni/Ag laminate film) for mounting or made of a current takeout surface interconnect (Al film or Cu film).

Between the substrate 1 and the upper conductor film 3, the ohmic contact is formed.

### <Method>

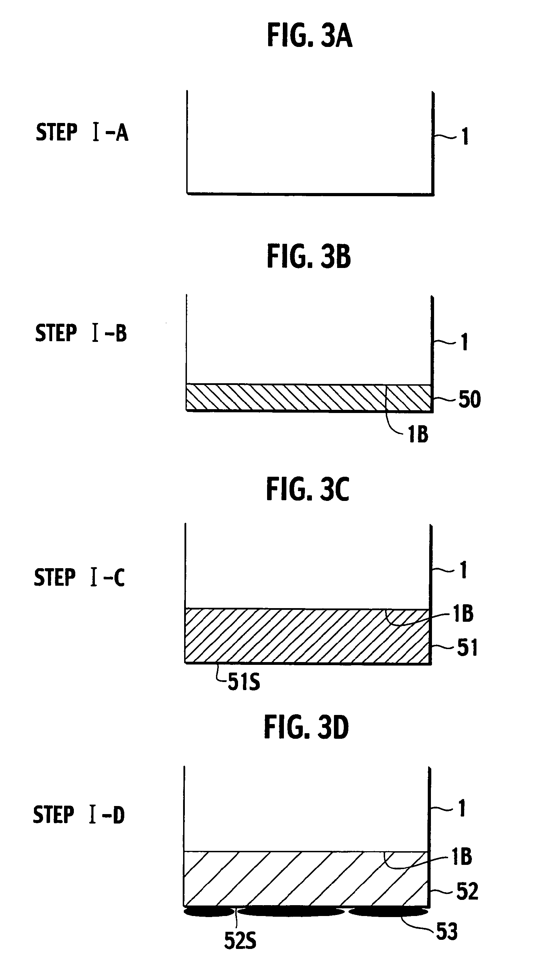

Then, a method for producing the silicon carbide semiconductor device 10 shown Fig. 2 is to be described, referring to cross sectional steps in Fig. 3A to Fig. 3F.

Herein, the low resistance n⁺ type 4H-SiC substrate 1 is the silicon carbide substrate having a main surface 1A (upper in Fig. 2) which is (0001) Si face. On a main backface 1B (lower in Fig. 2) of the low resistivity n⁺ type 4H-SiC substrate 1, the ohmic contact having the upper conductor film 3 (metalized film) for mounting is formed. The ohmic contact may be, however, formed on the main surface 1A of the low resistivity n⁺ type 4H-SiC substrate 1, bringing about the same effect.

In the following description, (Step I-A) to (Step I-F) respectively correspond to Fig. 3A to Fig. 3F.

### (Step I-A)

At first, the n type SiC substrate (n⁺ type 4H-SiC) 1 which is the silicon carbide substrate for forming the contact is dry-oxidized at 1160° C, to thereby grow a thermally oxidized film on the main backface 1B of the silicon carbide substrate. Then, the thermally oxidized film is immediately removed by a buffered hydrofluoric acid solution, to thereby remove a low quality crystal layer on the surface layer of the silicon carbide substrate and expose a high quality crystal layer (Fig. 3A). The above sacrificial oxidization is essential for achieving low resistance of the contact, but can be omitted if such low resistance contact is not necessary.

### (Step I-B)

Then, the n type SiC substrate 1 is rinsed with ultra-pure water and dried. As shown in Fig. 3B, a contact parent material 50 is deposited on (beneath in Fig. 3B) the entire main backface 1B of the n type SiC substrate 1 through a film-forming such as DC spattering. Used for the contact parent material 50 includes a conductive material such as Ni, Co or the like. Through contact annealing, the above conductive material forms silicide and generates carbon as by-product. In the following steps, for convenience sake, the explanation is based on the contact parent material 50 made of Ni.

Film thickness of the contact parent material 50 is one of the essential factors giving a substantial effect on strip of the upper conductor film 3. The larger the film thickness of the contact parent material 50, the larger the carbon amount generated in the subsequent contact annealing, resulting in higher risk of the film strip. Therefore, the smaller film thickness of the contact parent material 50 is more preferable. However, the contact parent material 50 having a too small film thickness is not preferable, which may cause, from a certain decreased thickness, a rapid increase in contact resistance. In the progress of decreasing the film thickness of contact parent material 50, the optimum film thickness of the contact parent material 50 is found right before the contact resistance is rapidly increased. For example, the optimum film thickness of the contact parent material 50 is 50 nm for a sufficiently flat contact face, and about 100 nm for a ground face having irregularities on the contact face. The optimum film thickness of the contact parent material 50 may slightly vary with crystal quality, crystal system, polished (or ground) state and the like of the SiC substrate 1. Generally, the optimum film thickness of the contact parent material 50 is 15 nm to 250 nm, usually 25 nm to 125 nm.

### (Step I-C)

Then, immediately after the depositing of the contact parent material 50 (Ni), the substrate 1 is put on a rapid thermal annealer, to be subjected to a rapid thermal annealing (contact annealing) at 1000° C for 2 minutes in a high purity Ar atmosphere where water content and oxygen are drastically removed. After the thermal annealing, the Ni film (the contact parent material 50) deposited on the main backface 1 B of the substrate 1 makes a solid phase reaction with the SiC substrate 1, to be converted to a silicide electrode 51 in Fig. 3C. An interface between the n⁺ type SiC substrate 1 and the silicide electrode 51 presents an extremely low contact resistance. At this point in time, however, the excessive amount of carbon generated by the solid phase reaction is dispersed in the entire inner area of the silicide electrode 51.

### (Step I-D)

Then, the substrate 1 is subjected to a thermal annealing (surface segregation treatment) in a non-oxidized gas atmosphere at 100° C to 600° C. The carbon in an unstable state dispersed in the silicide electrode 51 actively moves toward a surface 51S of the silicide electrode 51, to be segregated as a graphite 53 as shown in Fig. 3D. The surface segregation treatment is to be implemented until the carbon concentration (mol concentration) in the lower carbon content silicide electrode 52 is decreased to 1/5 or less, preferably 1/10 or less the silicon concentration. After the surface segregation treatment, the silicide electrode 51 is converted to the lower carbon content silicide electrode 52.

In the thermal annealing at Step I-D, for the following reason, the graphite 53 is segregated on a surface 52S of the lower carbon content silicide electrode 52, instead of in the lower carbon content silicide electrode 52. Reason: At this point in time, the upper conductor film 3 as an obstacle is not present. Therefore, depositing the graphite 53 on the surface having a free space is easier and more stable thermodynamically than depositing the graphite 53 in the solid.

Herein, the rapid thermal annealer for the contact annealing at Step I-C in Fig. 3C can also be used for the Step I-D in Fig. 3D, thereby rationalizing the Step I-C and Step I-D.

Moreover, adding the following conditions (1) to (3) can decrease the treatment time, decrease the treatment temperature or secure the treatment.
(1) adding hydrogen or helium to a treatment gas.
(2) intermittently increasing or decreasing temperature.
(3) applying an ultrasonic vibration.

In view of the above, an example of a practical surface segregation treatment condition includes "temperature 400° C (constant) for 20 minutes in a pure hydrogen gas atmosphere.

### (Step I-E)

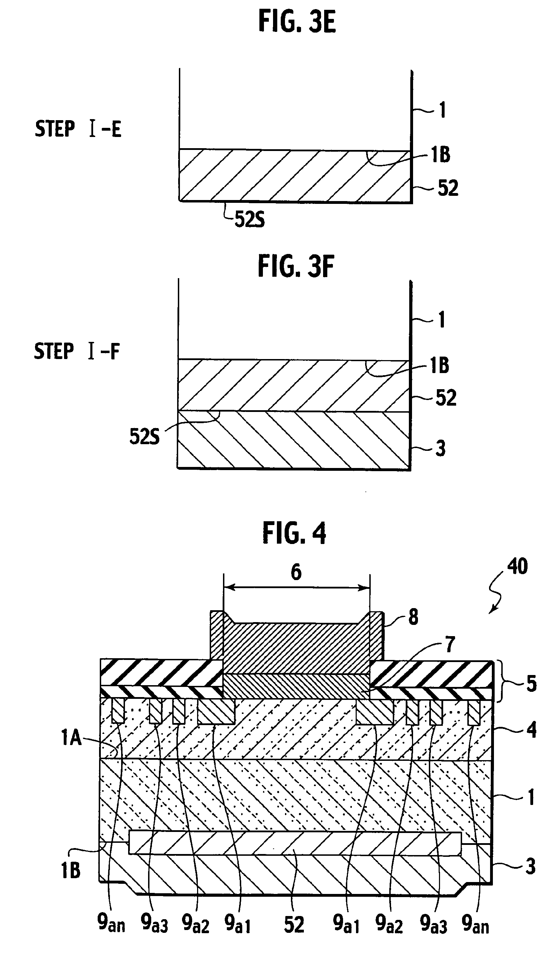

Then, as shown in Fig. 3E, the graphite 53 deposited on the surface of the lower carbon content silicide electrode 52 is snugly removed (graphite removal treatment), to thereby expose the lower carbon content silicide electrode 52.

The graphite removal treatment includes any of the following methods:
(1) Frictional operation method
   A method like the one used for an after-treatment (cleaning) of Chemical Mechanical Polish (CMP). Specifically, chemical tissue {for example, Clean Room Sponge or PVA [Polyvinyl Alcohol] Sponge (BELLCREAN) made of polyvinyl formal} wetted with pure water is used for mechanically rubbing and removing the graphite 53 on the surface of the lower carbon content silicide electrode 52. Otherwise, generally, a fiber aggregate wetted with a liquid can be used for mechanically rubbing and removing the graphite 53. The above frictional operation methods are, however, not proper when the lower carbon content silicide electrode 52 is formed in a dent part. In this case, the following methods are used.
(2) Chemical solution method
   A method for removing the graphite 53 with a chemical solution. In this method, the graphite 53 is not necessarily dissolved in the chemical solution, but as the case may be dispersed in the chemical solution for removal. Examples of the proper chemical solution includes ammonium fluoride solution, buffered hydrofluoric acid solution, nitric acid added-phosphoric acid acetic acid mixture, nitrohydrochloric acid, photo resist's stripping liquid and the like, but not limited thereto. Blowing the chemical solution to the surface of the lower carbon content silicide electrode 52, or dipping the substrate 1 in a chemical solution bath with an applied ultrasonic vibration is more effective.
(3) Oxidizing method
   A method of putting the substrate 1 in an active oxygen atmosphere such as oxygen plasma, UV (ultraviolet ray)/ozone and the like, so as to oxidize and thereby remove the graphite 53 using the above active oxygen in the gas phase.
   A commercialized photoresist ashing device (asher) without remodeling can be used for the oxidizing method.

Simultaneously implementing the method (1) to method (3) can accelerate the graphite removal treatment more effectively. For example, rubbing the graphite 53 by the chemical tissue wetted with the buffered hydrofluoric acid solution {i.e., combining method (1) with method (2)} can complete the graphite removal treatment in several tens of seconds.

### (Step I-F)

After the graphite 53 on (beneath in Fig. 3D and Fig. 3E) the lower carbon content silicide electrode 52 is thus removed, the substrate 1 is sufficiently cleaned. Immediately after that, for example, Ti, Ni and Ag as the upper conductor film 3 are sequentially deposited on (beneath in Fig. 3F) the surface 52S of the lower carbon content silicide electrode 52 of the substrate 1, by using a film forming method such as DC spattering, electron beam vacuum evaporation and the like. Herein, when patterning the upper conductor film 3 is necessary, photolithography and etching are to be implemented continuously. With this, the final structure (Fig. 3F) of the ohmic contact is completed. The final structure in Fig. 3F is the same as the structure of the silicon carbide semiconductor device 10 in Fig. 2, according to the first embodiment of the present invention.

As obvious from the structure in Fig. 2, the lower carbon content silicide electrode 52 to which the upper conductor film 3 is deposited does not substantially include the excessive amount of carbon causing the strip, thereby causing no segregation of the graphite 53, therefore causing no strip of the upper conductor film 3. In other words, according to the first embodiment, the following problem can be solved: "the upper conductor film 3 is suddenly stripped, thereby decreasing yield of the silicon carbide semiconductor device 10, leading to a failure after completing the silicon carbide semiconductor device 10."

The lower carbon content silicide electrode 52 not including the excessive amount of carbon causing the strip can be formed through the following operations: In the production method according to the first embodiment of the present invention, before forming of the upper conductor film 3, the excessive amount of carbon in the silicide electrode 51 is forcibly segregated as the graphite 53 on the main backface 1B (or the main surface 1A) of the substrate 1, and the thus segregated graphite 53 is removed.

### [Second embodiment]

According to a second embodiment, the present invention is applied to a vertical Schottky diode which is a 2-terminal type device.

### <Structure>

Fig. 4 shows a cross sectional view of an essential part of the vertical Schottky diode which is the silicon carbide semiconductor device 40, according to the second embodiment of the present invention. There is provided an n⁺ type single crystal 4H-SiC substrate 1 which is a silicon carbide substrate having impurity concentration of 1 × 10¹⁹/cm³ or more. The n⁺ type single crystal 4H-SiC substrate 1 has the main surface 1A (upper in Fig. 4), that is, (0001) Si face where a first n⁻ type epitaxial layer 4 having a thickness about 10 µm and added by nitrogen 5 × 10¹⁵/cm³ is homo-epitaxially grown.

In a certain region of a surface layer of the n⁻ type epitaxial layer 4, annular p type electric field relieving regions 9ₐ₁, 9ₐ₂, 9ₐ₃ to 9ₐₙ each having a width of 2 µm are formed at a distance of 2 µm through an ion implantation and activation annealing. The number (n) of electric field relieving regions 9ₐ₁, 9ₐ₂, 9ₐ₃ to 9ₐₙ vary with reverse blocking voltage, for example, five (n = 5) for reverse blocking voltage of 1000 V.

A field insulating film 5 having an opening part 6 covers the main surface 1A of the substrate 1. A Schottky electrode 7 contacting the n type epitaxial layer 4 is disposed on a bottom face of the opening part 6, forming a Schottky junction with the n⁻ type epitaxial layer 4. An outer end of the Schottky electrode 7 is disposed on the p type electric field relieving region 9ₐ₁ (innermost p type annular region). A main surface interconnect 8 mechanically electrically contacting the Schottky electrode 7 is so disposed as to block the field opening part 6. In a plan view of Fig. 4, an outer end of the main surface interconnect 8 is so designed as to be disposed outside the outer end of the Schottky electrode 7 and inside an outer end of the p type electric field relieving region 9ₐ₁.

There is provided a lower carbon content silicide electrode (ohmic electrode) 52 disposed on the main backface 1 B of the substrate 1. On (beneath in Fig. 4) the lower carbon content silicide electrode 52, the upper conductor film 3 for die bonding is disposed on (beneath in Fig. 4) the main backface 1B.

A rectifying property is caused between the Schottky electrode 7 and the upper conductor film 3, allowing the silicon carbide semiconductor device 40 to serve as the vertical Schottky diode, according to the second embodiment.

### <Method>

Then, a method for producing the silicon carbide semiconductor device 40 shown Fig. 4 is to be described, referring to cross sectional steps in Fig. 5A to Fig. 5G. In the following description, (Step II-A) to (Step II-G) respectively correspond to Fig. 5A to Fig. 5G.

### (Step II-A)

At first, the n⁺ type 4H-SiC substrate 1 is prepared (purchased) which is the silicon carbide substrate having the main surface 1A where the n⁻ type epitaxial layer 4 having a thickness about 10 µm is homo-epitaxially grown. Then, as shown in Fig. 5A, the p type electric field relieving regions 9ₐ₁, 9ₐ₂, 9ₐ₃ to 9ₐₙ are formed on the surface of the n⁻ type epitaxial layer 4 by a high temperature selective ion implantation.

For the above operation, at first, an SiO₂ film having thickness about 1.5 µm is deposited on the entire main surface 1A of the substrate 1 by a Chemical Vapor Deposition (CVD). Then, the SiO₂ film on a region for forming the high concentration impurity region is selectively removed by a photolithography (patterning using photoresist) and a dry-wet etching technology. Hereinabove, the dry-wet etching technology is a compound etching technology having the following operations in the removing of the SiO₂ film by an anisotropic dry etching such as reaction ion etching (RIE), inductive couple plasma (ICP) etching and the like: For keeping the main surface 1A of the substrate 1 from plasma damage, the dry etching is stopped right before the complete removal of the SiO₂ film, then, the remnant is removed by the wet etching using the buffered hydrofluoric acid solution and the like.

After etching the SiO₂ film, the photoresist is removed from the substrate 1, followed by a sufficient cleaning. Then, on the main surface 1A of the substrate 1, a thin SiO₂ film having thickness of 10 nm to 30 nm is deposited by a Low Pressure Chemical Vapor Deposition (LPCVD), to thereby form a through SiO₂ film.

After forming of the ion implantation mask as described above, a multi-step ion implantation of Al ⁺ion is implemented on the main surface 1 A of the substrate 1, to thereby form precursor regions 9ₐₚ₁, 9ₐₚ₂, 9ₐₚ₃ to 9ₐₚₙ of the p type electric field relieving regions 9ₐ₁, 9ₐ₂, 9ₐ₃ to 9ₐₙ. An example of ion implantation conditions for the p type electric field relieving regions 9ₐ₁, 9ₐ₂, 9ₐ₃ to 9ₐₙ is shown below.

Ion implantation conditions for the p type electric field relieving regions 9ₐ₁, 9ₐ₂, 9ₐ₃ to 9ₐₙ:
Temperature of substrate 1 700° C
Acceleration energy (voltage)/Dose

| | |
|---|---|
| First phase | 300 keV/8.3 × 10¹⁵/cm² |
| Second phase | 190 keV/3.2 × 10¹⁵/cm² |
| Third phase | 150 keV/2.1 × 10¹⁵/cm² |
| Fourth phase | 100 keV/1.9 × 10¹⁵/cm² |
| Fifth phase | 60 keV/1.7 × 10¹⁵/cm² |
| Sixth phase | 30 keV/9.4 × 10¹⁴/cm² |

After the completion of the ion implantation, the substrate 1 is dipped in the buffered hydrofluoric acid solution, to thereby remove all SiO₂ films (mask film and through film) on the main surface 1A and main backface 1B, followed by drying. Then, the activation annealing is implemented in a high purity Ar atmosphere at a temperature of 1650° C for about 1 minute for activating the precursor regions 9ₐₚ₁, 9ₐₚ₂, 9ₐₚ₃ to 9ₐₚₙ of the p type electric field relieving regions 9ₐ₁, 9ₐ₂, 9ₐ₃ to 9ₐₙ, to thereby form the p type electric field relieving regions 9ₐ₁, 9ₐ₂, 9ₐ₃ to 9ₐₙ. With this, the structure shown in Fig. 5A is formed.

### (Step II-B)

Then, after the activation of the p type electric field relieving regions 9ₐ₁, 9ₐ₂, 9ₐ₃ to 9ₐₙ, the substrate 1 is sufficiently cleaned and dried, followed by a sacrificial oxidization at 1100° C in a dry oxygen atmosphere, to thereby grow a thermally oxidized film on both the main surface 1A and main backface 1B of the substrate 1. Then, the substrate 1 is dipped in the buffered hydrofluoric acid solution, to thereby remove the thermally oxidized film on the main surface 1A and main backface 1B of the substrate 1 (sacrificial oxidization) . The thermally oxidized film has a thickness less than 50 nm, or preferably 5 nm to 20 nm.

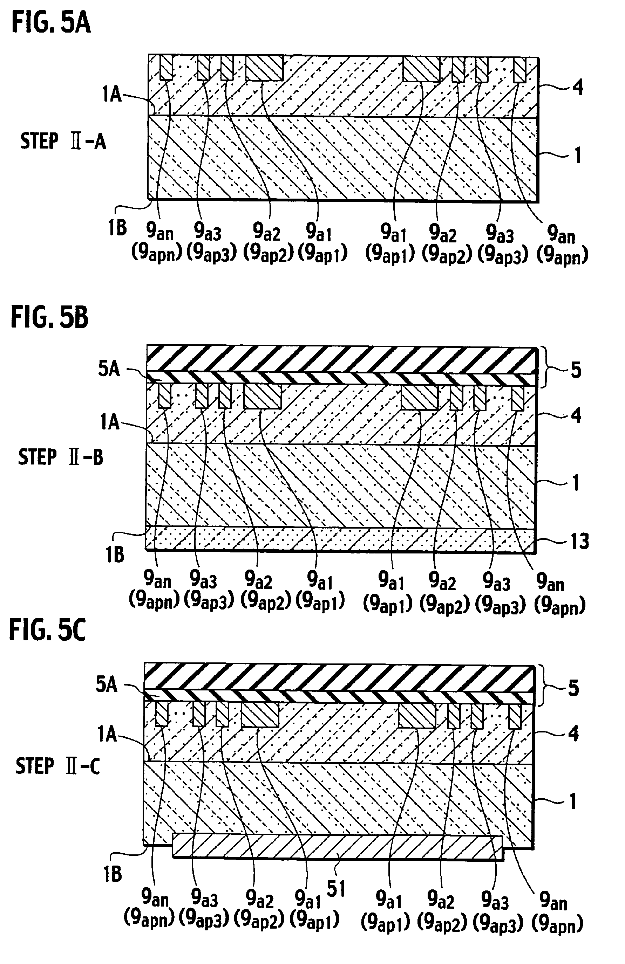

After the sacrificial oxidizing of the surface of the substrate 1, the substrate 1 is sufficiently cleaned, followed by a thermal oxidization at 1100° C in a dry oxygen atmosphere, to thereby a grow thermally oxidized film (having thickness of 5 nm to 20 nm) on both of the entire main surface 1A and entire main backface 1B of the substrate 1. Then, the SiO₂ film (600 nm thickness) is deposited on the thermally oxidized film by using Atmospheric Pressure Chemical Vapor Deposition (APCVD) and the like, to thereby form the field insulating film 5 of 2-layer structure including the thermally oxidized film and the APCVD-SiO₂ film, as shown in Fig. 5B. On the main backface 1B of the substrate 1, the thermal oxidization also forms a thermally oxidized film 13 having a thickness of 100 nm or more.

A thermally oxidized film 5A which is a lower layer of the field insulating film 5 brings about such effects as stabilizing an interface between the field insulating film 5 and the main surface 1A of the SiC substrate 1, increasing high voltage capability of the vertical device (silicon carbide semiconductor device 40), and suppressing variation of the high voltage capabilities. The thermally oxidized film 13 of the main backface 1B of the substrate 1 removes low quality crystal layer of the main backface 1B of the substrate 1, thereby decreasing the contact resistance.

### (Step II-C)

Then, a protective photoresist is applied on the field insulating film 5, then the substrate 1 is dipped in the buffered hydrofluoric acid solution, and then the thermally oxidized film 13 formed on the main backface 1B is removed, to thereby expose the main backface 1B of the substrate 1. Then, the substrate 1 is sufficiently rinsed with a ultra-pure water and sufficiently dried. Then, the contact parent material is vacuum-evaporated to the exposed main backface 1B of the substrate 1 by the film forming method such as DC spattering and the like. In this case, it is preferable to implement the vacuum evaporation by using a shadow mask and the like in such a manner that the periphery of the main backface 1 B of the substrate 1 is free from adhesion of the ohmic electrode parent material. Examples of the contact parent material include Ni, Co and the like having a thickness of 100 nm.

After the vacuum evaporation of the contact parent material, the substrate 1 is dipped in a special photoresist-stripper solution, thereby completely stripping the protective photoresist. Then, the substrate 1 is sufficiently cleaned and rinsed, followed by drying. Immediately after that, the substrate 1 is disposed in the rapid thermal annealer, to be subjected to the rapid thermal annealing (contact annealing) in a high purity Ar atmosphere at 1000° C for 2 minutes. Through the rapid thermal annealing, the contact parent material (Ni film and the like) deposited on the main backface 1B of the substrate 1 makes a solid phase reaction with the main backface 1B of the n⁺ type SiC substrate 1, as shown in Fig. 5C, to be converted to the silicide electrode 51 including an excessive amount of carbon, thus presenting an extremely low contact resistance to the substrate 1. The achieved contact resistance of the silicide electrode 51 is in the order of 10⁻⁶ Ωcm² (0.000001 Ωcm² to 0.00001 Ωcm²) or less which is ignorably small compared with an on resistance of the Schottky diode (silicon carbide semiconductor device 40).

### (Step II-D)

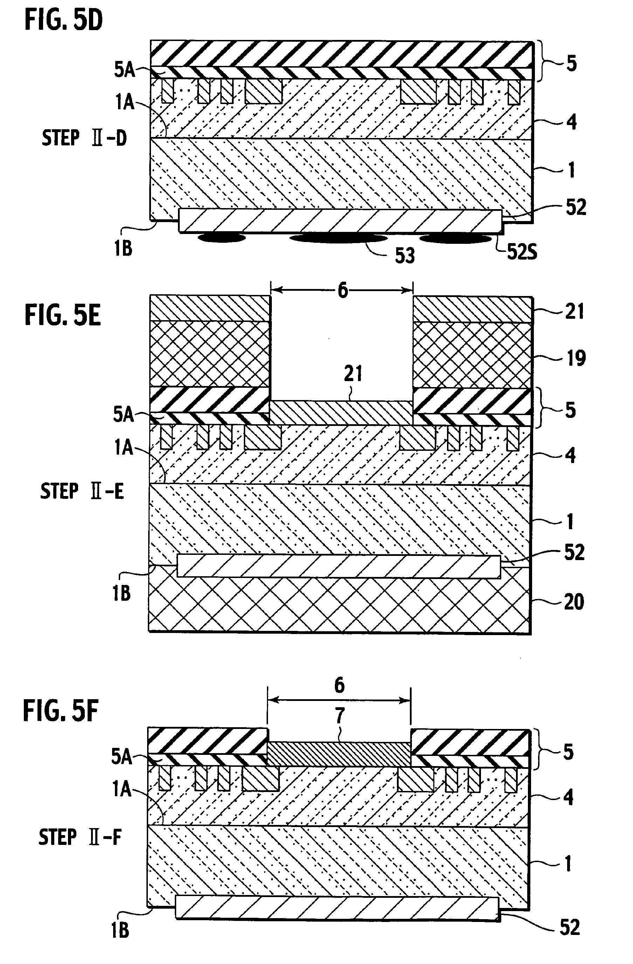

Then, the surface segregation treatment step (Fig. 3D) and the graphite removal treatment step (Fig. 3E) according to the first embodiment are likewise implemented. Thereby, as shown in Fig. 5D, the silicide electrode 51 including the excessive amount of carbon is converted to the lower carbon content silicide electrode 52, and the graphite 53 deposited on the surface 52S (lower in Fig. 5D) of the lower carbon content silicide electrode 52 is removed.

### (Step II-E)

Then, after forming the lower carbon content silicide electrode 52, the main surface 1A of the substrate 1 is subjected to the photolithography, to thereby form a photoresist pattern 19 for opening the opening part 6 in the surface of the field insulating film 5.

Then, a photoresist 20 is applied to the main backface 1B of the substrate 1, such that the lower carbon content silicide electrode 52 is completely covered and thereby protected. Then, the photoresist pattern 19 on the main surface 1 A and the photoresist 20 on the main backface 1B are subjected to a post bake. Then, i) the wet etching using the buffered hydrofluoric acid solution or ii) the above described dry-wet etching is implemented (see Step II-A). Then, the opening part 6 is formed in the field insulating film 5, to thereby expose the n- type epitaxial layer 4 at the bottom of the opening part 6 (opening etching).

With the above operations, the SiC epitaxial layer 4 is exposed through the opening part 6. Then, the substrate 1 is sufficiently rinsed with a ultra-pure water and dried. Soon after that, the substrate 1 is immediately installed in a high vacuum electron beam vacuum evaporator, to thereby form a preferable Schottky electrode material 21 (Ti 50 nm thick) on the entire main surface 1A of the substrate 1. With this, the structure shown in Fig. 5E is formed. When the Schottky electrode material 21 includes such materials as Ti and A1 which are likely to be oxidized or dissolved with a pure water or a photoresist-stripper solution, a conductor film (for example, Pt having thickness of 50 nm to 150 nm) for preventing oxidization is further formed continuously on the Schottky electrode material 21.

### (Step II-F)

Then, the substrate 1 is dipped in a special photoresist-stripper solution, to thereby completely remove the photoresist pattern 19 on the main surface 1A and the photoresist 20 on the main backface 1B. Fig. 5F shows a cross sectional shape of the substrate 1 where the stripper solution is sufficiently rinsed with a ultra-pure water and the like, followed by drying of the substrate 1. As obvious from Fig. 5F, the Schottky electrode 7 is left only at the bottom (surface of n⁻ type epitaxial layer 4) of the opening part 6, and the Schottky electrode material 21 on the photoresist pattern 19 is removed together with the dissolved photoresist pattern 19. Herein, when the above-described conductor film (for example, Pt having thickness of 50 nm to 150 nm) for preventing oxidization is deposited continuously on the Schottky electrode material 21, such conductor film having the same configuration as that of the Schottky electrode 7 is laminated on the Schottky electrode 7.

### (Step II-G)

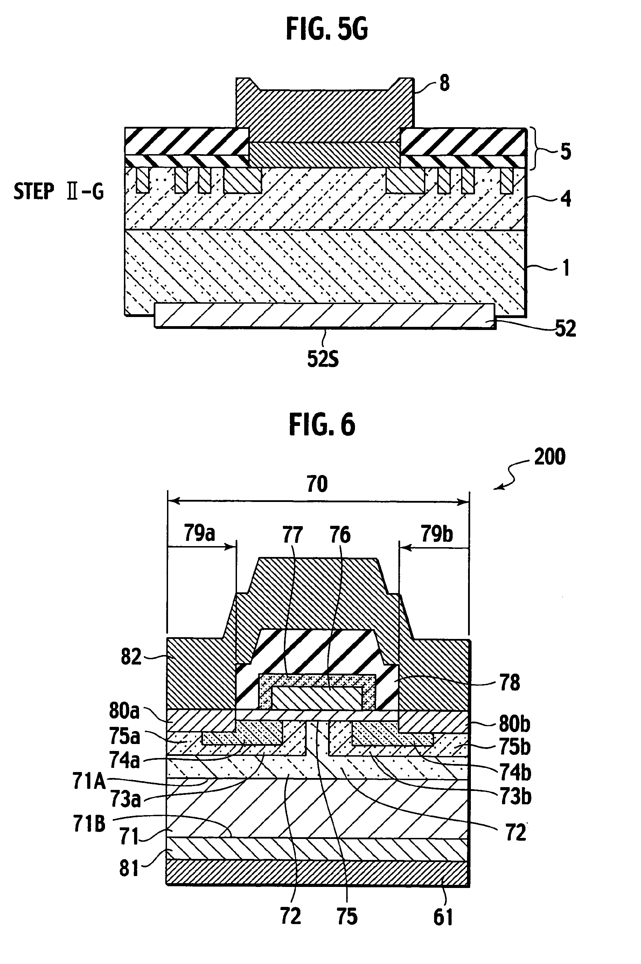

Then, the DC magnetron spattering or the like is used for vacuum evaporating a thick surface interconnect material on the entire main surface 1A of the substrate 1. Then, the surface interconnect material is patterned with the dry etching such as a known photolithography, RIE and the like, to thereby form the main surface interconnect 8, resulting in the structure shown in Fig. 5G Examples of the surface interconnect material include a laminate film formed by continuously vacuum evaporating Ti (50 nm thick) and A1 (2 µm thick).

### (Step II-H)

Finally, on (beneath in Fig. 4) the entire backface 1B (i.e., the surface 52S of the lower carbon content silicide electrode 52) of the cleaned and dried substrate 1, a conductor material used for die bond mounting and the like is vacuum-evaporated by using the DC magnetron spattering and the like, to thereby form the upper conductor film 3 on (beneath in Fig. 4) the main backface 1B, thus completing the Schottky diode having the final structure as shown in Fig. 4. An example of the upper conductor film 3 includes a Ti/Ni/Ag film where Ti (50 nm thick), Ni (100 nm thick) and Ag (150 nm thick) are sequentially laminated. The present invention is, however, not limited to this.

As obvious from the above description, according to the second embodiment as well, the lower carbon content silicide electrode 52 which is disposed on (beneath in Fig. 4) the main backface 1B and to which the upper conductor film 3 is deposited is a film free from the excessive amount of carbon causing the strip. Therefore, the graphite 53 is not deposited in the lower carbon content silicide electrode 52 or in the interface between the silicide electrode 52 and the upper conductor film 3. Therefore, the upper conductor film 3 is not stripped. In other words, according to the second embodiment, the following problem can be solved: "the upper conductor film 3 is suddenly stripped, thereby decreasing yield of the silicon carbide semiconductor device 40, leading to a failure after completing the silicon carbide semiconductor device 40."

The lower carbon content silicide electrode 52 not including the excessive amount of carbon causing the strip can be formed through the following operations: In the production method according to the second embodiment of the present invention, before forming of the upper conductor film 3, the excessive amount of carbon in the silicide electrode 51 is forcibly segregated as the graphite 53 on the main backface 1B (or the main surface 1A) of the substrate 1, and the thus segregated surface graphite 53 is removed.

Based on the structure of the semiconductor device 40 and the production method therefor according to the second embodiment of the present invention, 1000 samples of the vertical Schottky diodes are prepared each of which having the Schottky electrode 7's area about 1 × 1 mm². None of the 1000 samples presented a failure mode (strip) of the upper conductor film 3.

### [Third embodiment]

According to a third embodiment of the present invention, there is provided a vertical MOSFET (Metal-Oxide-Semiconductor Field Effect Transistor) which is a type of 3-terminal switching device. Moreover, the 3-terminal switching device has a silicide electrode type ohmic contact on both of a main surface 71A and a main backface 71B of an SiC substrate 71, according to the third embodiment of the present invention.

### <Structure>

Fig. 6 shows a cross sectional view of an essential part of a unit cell 70 of an SiC semiconductor MOSFET which is a silicon carbide semiconductor device 200, according to the third embodiment of the present invention. The unit cell 70 is a minimum unit of an active region. In a power element, many of the unit cells 70 are laterally arranged for greater current. Hereinafter, the reference numeral 70 is used for denoting both of the active region and the unit cell.

There is provided an n⁺ type single crystal 4H-SiC substrate 71 which is a silicon carbide substrate to which high concentration impurity is added. The n⁺ type single crystal 4H-SiC substrate 71 has the main surface 71A (upper in Fig. 6) where an n- type epitaxial layer 72 having a thickness about 10 µm and added by nitrogen 1 × 10⁻¹⁶/cm³ is homo-epitaxially grown. Other than 4H, all crystal systems such as 6H, 3C, 15R and the like (where H denotes hexagonal system, C denotes cubic system, and R denotes rhombohedral system) can be used for the SiC substrate 71.

In a certain region of the surface layer of the n⁻ type epitaxial layer 72, p type base regions 73a, 73b to which p type impurity having an impurity concentration higher than the impurity concentration of the n- type epitaxial layer 72 is added are spaced apart from each other.

In a certain region of the surface layer of the p type base regions 73a, 73b, n⁺ type source regions (high concentration impurity region) 74a, 74b are respectively formed which are smaller than the p type base regions 73a, 73b in thickness and larger than the p type base regions 73a, 73b in concentration of the added impurity. In a part of the p type base regions 73a, 73b and on an outer surface layer of the n⁺ type source regions 74a, 74b, there are respectively provided p⁺ type base regions 75a, 75b to which high concentration p type impurity is added. In terms of greater impurity concentration, the n- type epitaxial layer 72, the p type base regions 73a, 73b, and the n⁺ type source regions 74a, 74b are arranged in this order.

In sum, the main surface 71A of the SiC substrate 71 is formed with the above impurity regions. On the main surface 71A, there is provided a gate oxide film 75. On the gate oxide film 75, there is provided a gate electrode 76 made of conductive polycrystalline silicon. On side faces and an upper face of the gate electrode 76, there is provided a polycrystalline silicon thermally oxidized film 77. On the gate oxide film 75 and the polycrystalline silicon thermally oxidized film 77, there is provided an interlayer dielectric film 78.

There are provided source windows 79a, 79b which are opened in the interlayer dielectric film 78 and the gate oxide film 75 in such a manner as to penetrate through in a range striding over the n⁺ type source regions 74a, 74b and p⁺ type base regions 75a, 75b on the main surface 71A of the SiC substrate 71. At the bottom of the source windows 79a, 79b, there are respectively provided source electrodes 80a, 80b each serving as a first lower carbon content silicide electrode. The source electrodes 80a, 80b are capable of giving ohmic contact simultaneously to both heteropolar regions, that is, the n⁺ type source regions 74a, 74b and the p⁺ type base regions 75a, 75b. There is provided a main surface interconnect 82 which is a type of upper conductor film for wiring the n⁺ type source regions 74a, 74b or the p⁺ type base regions 75a, 75b with an outer circuit or with other circuit elements on the same substrate 71.

Meanwhile, on (beneath in Fig. 6) the main backface 71B of the substrate 71, there is provided a drain electrode 81 serving as a second lower carbon content silicide electrode for giving ohmic contact to a drain of the MOSFET cell. On (beneath in Fig. 6) the drain electrode 81, there is provided a main backface interconnect 61 (a kind of upper conductor film) for implementing the die bonding smoothly.

With the above structure, the silicon carbide semiconductor device 200 serves as the vertical metal-oxide-semiconductor field effect transistor (MOSFET), according to the third embodiment of the present invention.

### <Method>

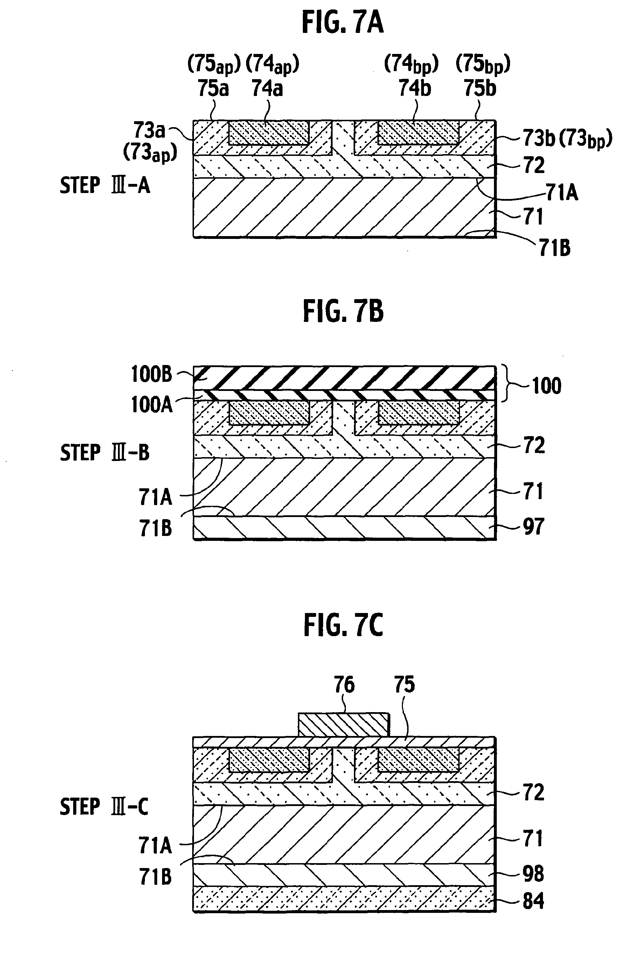

Then, a method for producing the silicon carbide semiconductor device 200 (MOSFET cell using 4H-SiC substrate) shown Fig. 6 is to be described, referring to cross sectional steps in Fig. 7A to Fig. 7H. In the following description, (Step III-A) to (Step III-H) respectively correspond to Fig. 7A to Fig. 7H.

### (Step III-A)

At first, the n⁺ type 4H-SiC substrate 71 is prepared (purchased) which is the silicon carbide substrate having the main surface 71A where the n⁻ type epitaxial layer 72 having a thickness about 10 µm is homo-epitaxially grown. Then, by the high temperature selective ion implantation at (Step II-A) according to the second embodiment, precursor regions 73ap, 73bp for the p type base regions 73a, 73b, precursor regions 75ap, 75bp for the p⁺ type base regions 75a, 75b, and precursor regions 74ap, 74bp for the n⁺ type source regions 74a, 74b are sequentially formed in the certain region. Examples of ion implantation conditions for each of the regions 73a, 73b, 74a, 74b, 75a, 75b are shown below.

| Ion implantation conditions for p type base regions 73a, 73b: | |
|---|---|
| Impurity | A1⁺ ion |
| Temperature of substrate 71 | 750° C |
| Acceleration energy (voltage)/Dose | 360 keV/5 × 10¹³/_{cm}² |

| Ion implantation conditions for p⁺ type base regions 75a, 75b: | |
|---|---|
| Ion | A1⁺ |
| Implantation temperature | 750° C |

| Acceleration energy (voltage)/Dose | |
|---|---|
| 30 keV | 1.0 × 10¹⁵/cm² |
| 50 keV | 1.0 × 10¹⁵/cm² |
| 70 keV | 2.0 × 10¹⁵/cm² |
| 100 keV | 3.0 × 10¹⁵/cm² |

| Ion implantation conditions for n⁺ type source regions 74a, 74b: | |
|---|---|
| Ion | P⁺ (phosphor) |
| Implantation temperature | 500° C |

| Acceleration energy (voltage)/Dose | |
|---|---|
| 40 keV | 5.0 × 10¹⁴/cm² |
| 70 keV | 6.0 × 10¹⁴/cm² |
| 100 keV | 1.0 × 10¹⁵/cm² |
| 160 keV | 2.0 × 10¹⁵/cm² |

After the completion of the high temperature ion implantation, the final ion implantation mask formed on the substrate 71 is dipped in a buffered hydrofluoric acid solution, to thereby remove the mask, followed by sufficient cleaning of the substrate 71 and drying. An activation annealing is implemented for simultaneously activating all precursor regions 73ap, 73bp, 74ap, 74bp and 75ap, 75bp on the main surface 71A of the substrate 71, to thereby form the p type base region 73a, 73b, the n⁺ type source regions 74a, 74b, and the p⁺ type base regions 75a, 75b. Fig. 7A shows a structure at the Step III-A.

The activation is implemented in the following manner: On a high purity carbon susceptor, the substrate 71 is disposed with the main surface 71 A turning upward (that is, main backface 7 1 B contacting the susceptor), then a rapid thermal annealing is implemented at 1600° C or more for 1 minute to several minutes in a high purity inactive gas (for example, Ar) atmosphere or in a high purity inactive gas atmosphere slightly including silane.

### (Step III-B)

After the activation of the impurity region of the main surface 71 A of the substrate 71, the substrate 71 is sufficiently cleaned and dried. Then, the substrate 71 is subjected to a sacrificial oxidization at 1100° C in a dry oxygen atmosphere, to thereby grow a thermally oxidized film on the main surface 71 A of the substrate 71. Then, the substrate 71 is dipped in a buffered hydrofluoric acid solution, to thereby remove the thermally oxidized film on the main surface 71 A of the substrate 71 (sacrificial oxidization). The thermally oxidized film has a thickness of less than 50 nm, or preferably 5 nm to 20 nm. The sacrificial oxidization can properly remove from the main surface 71A of the substrate 71 a contaminant layer and a mismatching layer which cause failure to the silicon carbide semiconductor device 200.

After the sacrificial oxidization, the substrate 71 is sufficiently cleaned, and thermally oxidized at 1100° C in a dry oxygen atmosphere, to thereby grow a thermally oxidized film (about 5 nm to 20 nm thick) on the entire main surface 71 A and entire main backface 71B of the substrate 71. Then, on the main surface 71A of the substrate 71, a thick (600 nm thick) SiO₂ film is deposited by using Atmospheric Pressure Chemical Vapor Deposition (APCVD) and the like, to thereby form a 2-layer field insulating film 100 having a thermally oxidized film 100A and an APCVD-SiO₂ film 100B, as shown in Fig. 7B. The thermal oxidization also forms on (beneath in Fig. 7B) the main backface 7 1 B a transient thermally oxidized film 97 having thickness of 100 nm or more.

The thermally oxidized film 100A which is the lower layer of the field insulating film 100 in Fig. 7B stabilizes an interface between the field insulating film 100 and the main surface 71A of the SiC substrate 71, increasing high voltage capability of the vertical device (silicon carbide semiconductor device 200), thus suppressing the variation of the vertical device.

### (Step III-C)

Then, a known photolithography and a known wet etching (or above-described dry-wet etching - see Step II-A and Step II-E) are used for selectively etching the field insulating film 100 on the main surface 71A of the substrate 71, to thereby form i) a field region and ii) the active region 70 (Fig. 6) with the field insulating film 100 removed. The transient thermally oxidized film 97 disappears after the wet etching. The active region 70 at the Step III-C in Fig. 7C has substantially the same structure as that at the Step III-B in Fig. 7B. In this case, however, an area other than the active region 70 has the field insulating film 100, making the entire SiC substrate 71 in Fig. 7C different in structure from that in Fig. 7B.

Then, the substrate 71 is again sufficiently cleaned. At the final step of the cleaning, for removing the chemical oxidized film (SiO₂₎ generated on the surface of the active region 70, the substrate 71 is dipped in a buffered hydrofluoric acid solution for 5 seconds to 10 seconds, then, the buffered hydrofluoric acid solution is completely rinsed off with a ultra-pure water, followed by a drying, and an immediate thermal oxidization, to thereby grow the gate oxide film 75 (for example, 40 nm thick) on the main surface 71A of the substrate 71 of the active region 70. Through the gate oxidization, a transient thermally oxidized film 98 (another transient thermally oxidized film after the transient thermally oxidized film 97) is formed on the main backface 71B. The gate oxidization condition is not limited to the above, for example, dry oxidizing at temperature 1160° C is, however, preferable. An essential point herein is that the thermally oxidized temperature is set higher than any other thermal annealing temperatures in the subsequent steps.

Then, a polycrystalline silicon film 84 having a thickness of 300 nm to 400 nm is formed on the entire main surface 71 A and entire main backface 71B of the substrate 71 through a Low Pressure CVD (growth temperature 600° C to 700° C) using a silane raw material. Then, P (phosphor) is added to the polycrystalline silicon film 84 by using a known heat diffusion (treatment temperature of 900° C to 950° C) using i) phosphorus chloride oxide (POCl₃) otherwise referred to as phosphoryl chloride and ii) oxygen, to thereby give conductivity to the polycrystalline silicon film 84. Then, a photoresist is applied to the main surface 71A of the substrate 71, then unnecessary part of the polycrystalline silicon film 84 on the main surface 71A of the substrate 71 side is removed by using i) a photolithography and ii) an Reactive Ion Etching (RIE) with C₂F₆ and oxygen as etchant, to thereby form the gate electrode 76, resulting in the structure shown in Fig. 7C.

### (Step III-D)

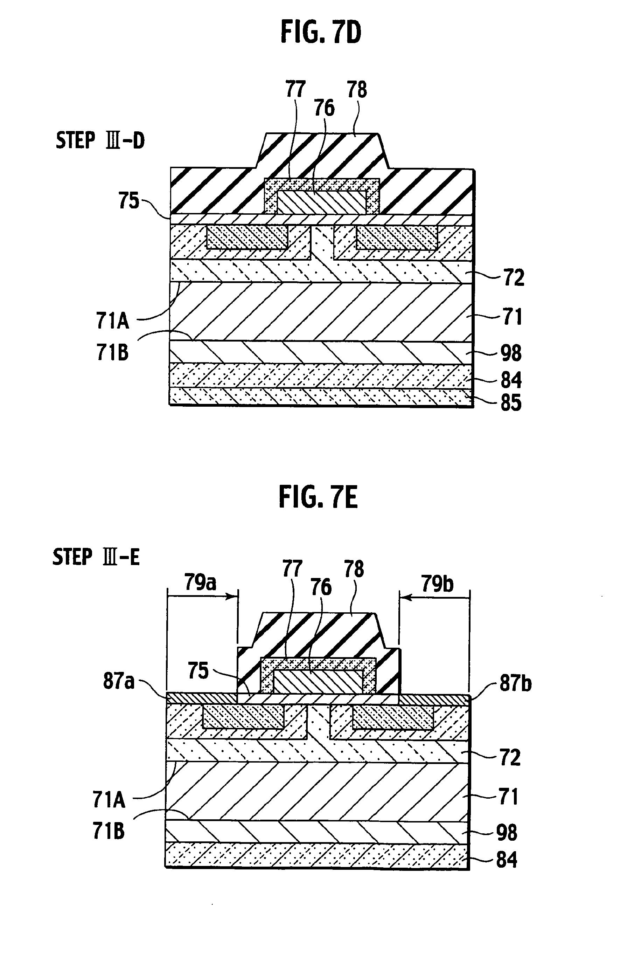

Then, the substrate 71 after the etching is sufficiently cleaned, followed by thermal oxidization at 900° C in a dry oxygen atmosphere, to thereby generate the polycrystalline silicon thermally oxidized film 77 on the gate electrode 76 and generate a polycrystalline silicon thermally oxidized film 85 on (beneath in Fig. 7D) the surface of the polycrystalline silicon film 84 of the main backface 71B.

Then, as shown in Fig. 7D, the interlayer dielectric film 78 is deposited on the entire main surface 71 A of the substrate 71. Proper examples of the interlayer dielectric film 78 include:
i) SiO₂ film (NSG [None-doped Silicate Glass]) about 1 µm thick formed by APCVD with silane and oxygen as raw materials,
ii) phosphor-silicate-glass (PSG) to which phosphor is added, and
iii) boron-phosphor-silicate glass (BPSG) formed by the above ii) added by boron,
iv) and the like, but not limited to the above.
Then, the substrate 71 is put in an ordinary diffusion furnace, to be subjected to a calm thermal annealing in an N₂ atmosphere for several tens of minutes, to thereby increase concentration of the interlayer dielectric film 78. The above thermal annealing temperature is lower than the temperature for forming (thermal oxidization) a gate insulating film, for example, properly selected from 900° C to 1000° C.

### (Step III-E)

Then, a known photolithography and the dry-wet etching (see Step II-A, Step II-E and Step III-C) are used for opening the source windows 79a, 79b and a gate window (not shown in Fig. 7E since being outside the active region 70) respectively in the interlayer dielectric film 78 and the gate oxide film 75 which are disposed on the main surface 71A of the substrate 71. In this case, the polycrystalline silicon thermally oxidized film 85 on the main backface 71B of the substrate 71 is also removed simultaneously.

After the etching, the substrate 71 wearing the photoresist mask is sufficiently rinsed with a ultra-pure water and dried. Then immediately, by using a film forming such as electron beam vacuum evaporation, DC magnetron spattering and the like, contact parent materials 87a, 87b are vacuum-evaporated on the entire surface 71A of the substrate 71. Then, the photoresist is stripped as shown in Fig. 7E, leaving the contact parent materials 87a, 87b only at the bottom of the respective source windows 79a, 79b and the bottom of the gate window (not shown in Fig. 7E since being outside the active region 70). Examples of the contact parent materials 87a, 87b include Ni, Co and the like (50 nm thick), but not specifically limited thereto.

### (Step III-F)

Then, the substrate 71 is sufficiently cleaned and dried, and a protective resist material (photoresist is allowed) having a thickness of 1 µm or more is applied to the entire main surface 71A, followed by a dry etching with CF₄ and O₂, to thereby completely remove the polycrystalline silicon film 84 on the main backface 71B. Then, the substrate 71 is dipped in a buffered hydrofluoric acid solution, to thereby remove the SiO₂ film 98 on the main backface 71B, thus exposing a clarified crystal face on the backface 71B of the substrate 71.

Then, the substrate 71 having the main surface 71 A wearing the protective resist material is sufficiently cleaned and dried, and is rapidly installed in a high vacuum evaporator, to thereby vacuum-evaporate a preferable contact parent material 89 on the backface 71B of the substrate 71. Examples of the contact parent material 89 for the main backface 71B include Ni film and the like having thickness of 50 nm to 150 nm.

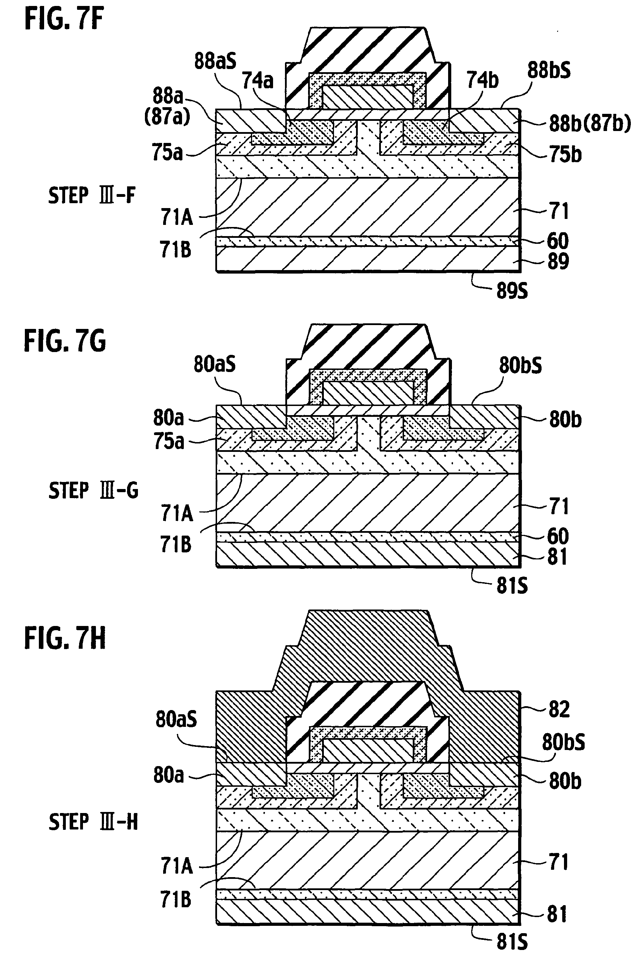

After the film forming of the contact parent material 89, a special stripping agent is used for completely removing the protective resist on the main surface 71A, to thereby sufficiently clean the substrate 71. Immediately after being dried, the substrate 71 is disposed in a rapid thermal annealer, to be subjected to a thermal annealing (contact annealing) in a high purity Ar atmosphere at 1000° C for 2 minutes. Through the thermal annealing, the contact parent materials 87a, 87b of the source windows 79a, 79b and gate window (the gate window bottom is not shown), and a contact parent material on an n⁺⁺ type drain region 60 (high concentration impurity region) on the backface 71 B of the substrate 71 make a solid phase reaction with a background, to thereby form source electrodes 88a, 88b, the drain electrode 89 serving as silicide electrodes including an excessive amount of carbon, bringing about a low resistance ohmic contact to the source and drain (gate window bottom gate contact is also simultaneously formed but not shown in Fig. 7F). The thus formed source electrodes 88a, 88b and drain electrode 89 each show an extremely low contact resistance in the order of 10⁻⁶ Ωcm² (0.000001 Ωcm² to 0.00001 Ωcm²) or less.

### (Step III-G)

After the contact annealing, the surface segregation treatment step (Step I-D in Fig. 3D) and the graphite removal treatment step (Step I-E in Fig. 3E) according to the first embodiment are likewise implemented, to thereby remove the excessive amount of carbon from the source electrodes 88a, 88b and the drain electrode 89, thus forming the source electrodes 80a, 80b (the first lower carbon content silicide electrode) and the drain electrode 81 (the second lower carbon content silicide electrode), resulting in the structure shown in Fig. 7G

### (Step III-H)

Then, the substrate 71 is sufficiently cleaned and dried, and a main surface interconnect (main surface upper conductor film) material, for example, Al is formed on the entire main surface 71A (or a surface 80aS and a surface 80bS in Fig. 7H) by the DC magnetron spattering and the like. Then, the thus obtained is patterned by the photolithography and the dry etching technology (RIE and the like), then the photoresist is stripped, followed by cleaning and drying, to thereby form the main surface interconnect 82 as shown in Fig. 7H.

A conductor such as Ti, TiN, TaN and the like is, as the case may be, inserted between the main surface interconnect 82 and the source electrodes 80a, 80b for improving i) adhesion force, ii) contact resistance and iii) heat resistance of both of the above conductors 82, 80a, 80b. In this case, these materials are, at first, subjected to film forming, followed by the above forming of the surface interconnect film material. When the surface interconnect film material is made of A1, an etchant gas same as A1 can continuously pattern the above materials.

### (Step III-1)

Finally, on the entire main backface 71B of the substrate 71, i.e., on (beneath in Fig. 7H) a surface 81S of the drain electrode 81, a main backface interconnect (main backface upper conductor film) material used for die bond mounting and the like is vacuum-evaporated by using the DC magnetron spattering and the like, to thereby form the main backface interconnect 61, thus completing the vertical MOSFET, that is, the silicon carbide semiconductor device 200, as shown in Fig. 6. An example of the main backface interconnect material includes Ti/Ni/Ag film where Ti (50 nm thick), Ni (100 nm thick) and Ag (150 nm thick) are sequentially laminated. The present invention is, however, not limited to this.

According to the third embodiment where the lower carbon content silicide electrodes are disposed both on the main surface 71A and main backface 71B of the substrate 71, each of the source electrodes 80a, 80b and drain electrode 81 as silicide electrode is a film with the excessive amount of carbon (causing strip) removed. Therefore, after completing the silicon carbide semiconductor device 200, the graphite is not segregated in the silicide electrodes (that is, 80a, 80b, 81) or not segregated to the interface between the silicide electrodes (that is, 80a, 80b, 81) and the upper conductor films (that is, 82, 61). In other words, according to the third embodiment, the following problem can be solved: "the upper conductor film, i.e., the source electrode or the drain electrode is suddenly stripped, thereby decreasing yield of the silicon carbide semiconductor device 200, leading to a failure after completing the silicon carbide semiconductor device 200."

The lower carbon content silicide electrodes 80a, 80b, 81 not including the excessive amount of carbon causing the strip can be formed through the following operations: In the production method (Step III-G) according to the third embodiment of the present invention, the excessive amount of carbon in the source electrodes 88a, 88b and the drain electrode 89 are forcibly segregated, as graphite, on the surface 71A of the substrate 71, and the thus deposited surface graphite is removed.

Based on the structure of the semiconductor device 200 and the production method therefor according to the third embodiment of the present invention, 200 samples of the power MOSFETs are prepared for temperature cycle test, each of the samples having the active region 70 about 0.25 × 0.25 mm². Most of the counterpart elements prepared simultaneously according to the related art in Fig. 1 caused strip to surface interconnect or backface interconnect, resulting in failure rate of 95% or more. Meanwhile, none of the 200 samples according to the third embodiment of the present invention presented a failure mode (strip).

Although the present invention has been described above by reference to three embodiments, the present invention is not limited to the three embodiments described above. Modifications and variations of the three embodiments described above will occur to those skilled in the art, in light of the above teachings.

This application is based on a prior Japanese Patent Application No. P2005-354281 filed on December 8, 2005 in Japan. The entire contents of the Japanese Patent Application No. P2005-354281 from which priority is claimed are incorporated herein by reference, in order to take some protection against translation errors or omitted portions.

The scope of the present invention is defined with reference to the following claims.

## Claims

1. A silicon carbide semiconductor device (10, 40, 200), comprising:
1) a silicon carbide substrate (1, 1, 71);
2) a silicide electrode [51(52), 51(52), {88a(80a), 88b(80b), 89(81)}] configured to be formed by depositing a contact parent material {50, 50, (87a, 87b, 89)} on the silicon carbide substrate (1, 1, 71) in such a manner as to cause a solid phase reaction, the silicide electrode [51(52), 51(52), {88a(80a), 88b(80b), 89(81)}] being a lower carbon content silicide electrode {52, 52, (80a, 80b, 81)} including:
i) silicon, and
ii) carbon smaller than the silicon in mol number; and
3) an upper conductor film {3, 3, (82, 61)} deposited to the silicide electrode [51(52), 51(52), {88a(80a), 88b(80b), 89(81)}).

2. The silicon carbide semiconductor device (10, 40, 200) as claimed in claim 1, wherein the lower carbon content silicide electrode {52, 52, (80a, 80b, 81)} includes the carbon 1/5 or less the silicon in mol number.

3. The silicon carbide semiconductor device (10, 40, 200) as claimed in claim 2, wherein the lower carbon content silicide electrode {52, 52, (80a, 80b, 81)} includes the carbon 1/10 or less the silicon in mol number.

4. The silicon carbide semiconductor device (10, 40, 200) as claimed in claim 1, wherein the lower carbon content silicide electrode {52, 52, (80a, 80b, 81)} has a thickness of 20 nm to 500 nm.

5. The silicon carbide semiconductor device (40) as claimed in any of claim 1 to claim 4, wherein the silicon carbide substrate (1) includes:
1) a first face (1A) contacting a Schottky electrode (7) such that the silicon carbide semiconductor device (40) is configured to serve as a vertical Schottky diode (40), and
2) a second face (1B) opposite to the first face (1A), the lower carbon content silicide electrode (52) being formed on the second face (1B).

6. The silicon carbide semiconductor device (200) as claimed in any of claim 1 to claim 4, wherein the silicon carbide semiconductor device (200) further comprises:
1) a source electrode {(88a(80a), 88b(80b)} including the lower carbon content silicide electrode (80a, 80b), and
2) a drain electrode {89(81)} including the lower carbon content silicide electrode (81),
allowing the silicon carbide semiconductor device (200) to serve as a field effect transistor (200) configured to be a vertical metal-oxide-semiconductor (200).

7. A method for producing a silicon carbide semiconductor device (10) which comprises: 1) a silicon carbide substrate (1); 2) a silicide electrode {51(52)} configured to be formed by depositing a contact parent material (50) on the silicon carbide substrate (1) in such a manner as to cause a solid phase reaction, the silicide electrode {51(52)} being a lower carbon content silicide electrode (52) including: i) silicon, and ii) carbon smaller than the silicon in mol number; and 3) an upper conductor film (3) deposited to the silicide electrode {51(52)},
the method comprising:
1) a first operation (Step I-B) for depositing the contact parent material (50) to the silicon carbide substrate (1);
2) a second operation (Step I-C) for implementing a contact annealing, including the following sub-operations:
i) heating the silicon carbide substrate (1) to which the contact parent material (50) is deposited, and
ii) forming the silicide electrode (51) by the solid phase reaction between the contact parent material (50) and the silicon carbide substrate (1);
3) a third operation (Step I-D) for segregating, to a surface (51S) of the silicide electrode (51), at least a part of carbon (53) generated through the second operation (Step I-C), to thereby allow the silicide electrode (51) to serve as the lower carbon content silicide electrode (52);
4) a fourth operation (Step I-E) for removing the at least the part of the carbon (53) segregated to the surface (51 S) of the silicide electrode (51) in the third operation (Step I-D); and
5) a fifth operation (Step I-F) for depositing the upper conductor film (3) to the following, after the removing of the carbon (53) in the fourth operation (Step I-E):
a surface (52S) of the silicide electrode {51(52)} serving as the lower carbon content silicide electrode (52) through the third operation (Step I-D).

8. The method for producing the silicon carbide semiconductor device (10) as claimed in claim 7, wherein the contact parent material (50) has a thickness of 15 nm to 250 nm.

9. The method for producing the silicon carbide semiconductor device (10) as claimed in claim 8, wherein the contact parent material (50) has the thickness of 25 nm to 125 nm.

10. The method for producing the silicon carbide semiconductor device (10) as claimed in claim 7, wherein the third operation (Step I-D) is implemented in the following conditions:
1) a treatment temperature of 100° C to 600° C, and
2) a non-oxidized gas atmosphere.

11. The method for producing the silicon carbide semiconductor device (10) as claimed in claim 10, wherein the non-oxidized gas atmosphere of the third operation (Step I-D) includes one of hydrogen and helium.

12. The method for producing the silicon carbide semiconductor device (10) as claimed in claim 10, wherein the third operation (Step I-D) is intermittently increases or decreases the treatment temperature.

13. The method for producing the silicon carbide semiconductor device (10) as claimed in claim 10, wherein the third operation (Step I-D) applies an ultrasonic vibration to the silicon carbide substrate (1).

14. The method for producing the silicon carbide semiconductor device (10) as claimed in claim 7, wherein the fourth operation (Step I-E) mechanically rubs the segregated carbon (53) with a fiber aggregate wetted with a liquid.

15. The method for producing the silicon carbide semiconductor device (10) as claimed in claim 7, wherein the fourth operation (Step I-E) removes the segregated carbon (53) with a chemical solution.

16. The method for producing the silicon carbide semiconductor device (10) as claimed in claim 15, wherein the chemical solution is selected from the group consisting of
1) an ammonium fluoride solution,
2) a buffered hydrofluoric acid solution,
3) a nitric acid added-phosphoric acid acetic acid liquid mixture,
4) a nitrohydrochloric acid, and
5) a striping liquid of photoresist.

17. The method for producing the silicon carbide semiconductor device (10) as claimed in claim 7, wherein the fourth operation (Step I-E) removes the segregated carbon (53) by oxidizing the segregated carbon (53) with an active oxygen in a gas phase.

18. The method for producing the silicon carbide semiconductor device (10) as claimed in claim 7, wherein the second operation (Step I-C) and the third operation (Step I-D) are continuously implemented by a single thermal annealer.

19. A method for producing a silicon carbide semiconductor device (40) which comprises: 1) a silicon carbide substrate (1); 2) a silicide electrode {51(52)} configured to be formed by depositing a contact parent material (50) on the silicon carbide substrate (1) in such a manner as to cause a solid phase reaction, the silicide electrode {51(52)} being a lower carbon content silicide electrode (52) including: i) silicon, and ii) carbon smaller than the silicon in mol number; and 3) an upper conductor film (3) deposited to the silicide electrode {51(52)}, wherein the silicon carbide substrate (1) includes: 1) a first face (1A) contacting a Schottky electrode (7) such that the silicon carbide semiconductor device (40) is configured to serve as a vertical Schottky diode (40), and 2) a second face (1B) opposite to the first face (1A), the lower carbon content silicide electrode (52) being formed on the second face (1B),
the method comprising:
1) a first operation (Step II-B) for covering the first face (1A) and the second face (1B) of the silicon carbide substrate (1) with a thermally oxidized film (5A, 13);
2) a second operation (Step II-C) including the following sub-operations:
i) removing at least a part of the thermally oxidized film (13) on the second face (1B) of the silicon carbide substrate (1), and
ii) exposing, thereby, the second face (1B) of the silicon carbide substrate (1, 1, 71);
3) a third operation (Step II-C) for depositing the contact parent material (50) on the thus exposed second face (1B);
4) a fourth operation (Step II-C) for implementing a contact annealing, including the following sub-operations:
i) heating the silicon carbide substrate (1) to which the contact parent material (50) is deposited, and
ii) forming the silicide electrode (51) by the solid phase reaction between the contact parent material (50) and the silicon carbide substrate (1);
5) a fifth operation (Step II-D: Step I-D) for segregating, to a surface (51S) of the silicide electrode (51), at least a part of carbon (53) generated through the fourth operation (Step II-C), to thereby allow the silicide electrode (51) to serve as the lower carbon content silicide electrode (52);
6) a sixth operation (Step II-D: Step I-E) for removing the at least the part of the carbon (53) segregated to the surface (51S) of the silicide electrode (51) in the fifth operation (Step II-D: Step I-D); and
7) a seventh operation (Step II-H) for depositing the upper conductor film (3) to the following, after the removing of the carbon (53) in the sixth operation (Step II-D: Step I-E):
a surface (52S) of the silicide electrode {51(52)} serving as the lower carbon content silicide electrode (52) through the fifth operation (Step II-D: Step I-D);
wherein the method further comprising the following operations after the fifth operation (Step II-D: Step I-D):
8) an eighth operation (Step II-E) including the following sub-operations:
i) removing at least a part of the thermally oxidized film (5A) on the first face (1A) of the silicon carbide substrate (1), and
ii) exposing, thereby, the first face (1A) of the silicon carbide substrate (1), and
9) a ninth operation (Step II-F) for forming the Schottky electrode (7) on the thus exposed first face (1A) of the silicon carbide substrate (1).

20. The method for producing the silicon carbide semiconductor device (40) as claimed in claim 19, wherein the lower carbon content silicide electrode (52) includes the carbon 1/5 or less the silicon in mol number.

21. The method for producing the silicon carbide semiconductor device (40) as claimed in claim 20, wherein the lower carbon content silicide electrode (52) includes the carbon 1/10 or less the silicon in mol number.

22. The method for producing the silicon carbide semiconductor device (40) as claimed in claim 19, wherein the lower carbon content silicide electrode (52) has a thickness of 20 nm to 500 nm.

23. A method for producing a silicon carbide semiconductor device (200) which comprises: 1) a silicon carbide substrate (71); 2) a silicide electrode {88a(80a), 88b(80b), 89(81)} configured to be formed by depositing a contact parent material (87a, 87b, 89) on the silicon carbide substrate (71) in such a manner as to cause a solid phase reaction, the silicide electrode {88a(80a), 88b(80b), 89(81)} being a lower carbon content silicide electrode (80a, 80b, 81) including: i) silicon, and ii) carbon smaller than the silicon in mol number; and 3) an upper conductor film (82, 61) deposited to the silicide electrode {88a(80a), 88b(80b), 89(81)}, wherein the silicon carbide semiconductor device (200) further comprises: 1) a source electrode {(88a(80a), 88b(80b)} including the lower carbon content silicide electrode (80a, 80b), and 2) a drain electrode {89(81)} including the lower carbon content silicide electrode (81), allowing the silicon carbide semiconductor device (200) to serve as a field effect transistor (200) configured to be a vertical metal-oxide-semiconductor (200),
the method comprising:
1) a first operation (Step III-A) for sequentially forming the following on a first face (71 A) of the silicon carbide substrate (71) by a selective impurity ion implantation:
i) a precursor region (73ap, 73bp) of a p type base region (73a, 73b),
ii) a precursor region (75ap, 75bp) of a p⁺ type base region (75a, 75b), and
iii) a precursor region (74ap, 74bp) of an n⁺ type source region (74a, 74b);
2) a second operation (Step III-A) for forming the n⁺ type source region (74a, 74b), the p type base region (73a, 73b) and the p⁺ type base region (75a, 75b) by a thermal annealing of the respective precursor regions {(73ap, 73bp), (74ap, 74bp), (75ap, 75bp)};
3) a third operation (Step III-B) including the following sub-operations:
covering, with a first thermally oxidized film (100A), the first face (71A) of the silicon carbide substrate (71) on which face the n⁺ type source region (74a, 74b), the p type base region (73a, 73b) and the p⁺ type base region (75a, 75b) are formed, and
covering, with a second thermally oxidized film {97(98)}, a second face (71B) of the silicon carbide substrate (71);
4) a fourth operation (Step III-E) including the following sub-operations:
i) removing (Step III-E) at least a part of each of the following:
a) the first thermally oxidized film (100A) on the n⁺ type source region (74a, 74b), and
b) the first thermally oxidized film (100A) on the p⁺ type base region (75a, 75b),
ii) exposing (Step III-E), thereby, the n⁺ type source region (74a, 74b) and the p⁺ type base region (75a, 75b), and
iii) depositing (Step III-E) the contact parent material (87a, 87b) on the thus exposed n⁺ type source region (74a, 74b) and the thus exposed p⁺ type base region (75a, 75b);
5) a fifth operation (Step III-F) including the following sub-operations:
i) removing (Step III-F) at least a part of the second thermally oxidized film (98) on the second face (71B) of the silicon carbide substrate (71),
ii) exposing (Step III-F), thereby, the second face (71B) of the silicon carbide substrate (71), and
iii) depositing (Step III-F) the contact parent material (89) on the thus exposed second face (71B) of the silicon carbide substrate (71);
6) a sixth operation (Step III-F) for implementing a contact annealing, including the following sub-operations:
i) heating the silicon carbide substrate (71) having the first face (71A) and the second face (71B) on each of which the contact parent material (87a, 87b, 89) is thus deposited, and
ii) forming the following by the solid phase reaction between the contact parent material (87a, 87b, 89) and the silicon carbide substrate (71):
a) a source electrode {88a(80a), 88b(80b)} which is the silicide electrode {88a(80a), 88b(80b)} contacting the n⁺ type source region (74a, 74b) and the p⁺ type base region (75a, 75b), and
b) a drain electrode {89(81)} which is the silicide electrode {89(81)} contacting the second face (7 1 B) of the silicon carbide substrate (71);
7) a seventh operation (Step III-G) for segregating, to a surface (88aS, 88bS, 89S) of the silicide electrode (88a, 88b, 89), at least a part of carbon (53) generated through the contact annealing in the sixth operation (Step III-F), to thereby allow the silicide electrode (88a, 88b, 89) to serve as the lower carbon content silicide electrode (80a, 80b, 81);
8) an eighth operation (Step III-G) for removing the at least the part of the carbon (53) segregated to the surface (88aS, 88bS, 89S) of the silicide electrode (88a, 88b, 89) in the seventh operation (Step III-G); and
9) a ninth operation (Step III-H, Step III-I) for depositing the upper conductor film (82, 61) to each of the following, after the removing of the carbon (53) at the eighth operation (Step III-G):
i) a surface (80aS, 80bS) of the source electrode {88a(80a), 88b(80b)} serving as the lower carbon content silicide electrode (80a, 80b) through the seventh operation (Step III-G), and
ii) a surface (81S) of the drain electrode {89(81)} serving as the lower carbon content silicide electrode (81) through the seventh operation (Step III-G).

24. The method for producing the silicon carbide semiconductor device (200) as claimed in claim 23, wherein the lower carbon content silicide electrode (80a, 80b, 81) includes the carbon 1/5 or less the silicon in mol number.

25. The method for producing the silicon carbide semiconductor device (200) as claimed in claim 24, wherein the lower carbon content silicide electrode (80a, 80b, 81) includes the carbon 1/10 or less the silicon in mol number.

26. The method for producing the silicon carbide semiconductor device (200) as claimed in claim 23, wherein the lower carbon content silicide electrode (80a, 80b, 81) has a thickness of 20 nm to 500 nm.
